(19) Europäisches Patentamt
European Patent Office
Office européen des brevets

(11) **EP 4 311 819 A1**

(12) **EUROPÄISCHE PATENTANMELDUNG**

(43) Veröffentlichungstag:
**31.01.2024   Patentblatt 2024/05**

(21) Anmeldenummer: **22187751.7**

(22) Anmeldetag: **29.07.2022**

(51) Internationale Patentklassifikation (IPC):
**C04B 37/02** (2006.01)   **H01L 21/306** (2006.01)
**H01L 23/15** (2006.01)   **C04B 41/53** (2006.01)

(52) Gemeinsame Patentklassifikation (CPC):
**C04B 37/021; C04B 37/026; H05K 3/00;**
C04B 2237/125; C04B 2237/343; C04B 2237/366;
C04B 2237/368; C04B 2237/402; C04B 2237/403;
C04B 2237/407; C04B 2237/64; H01L 23/3735

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(71) Anmelder: **Heraeus Electronics GmbH & Co. KG
63450 Hanau (DE)**

(72) Erfinder:
• **Sattler, Martin
63450 Hanau (DE)**

• **Wacker, Richard
63450 Hanau (DE)**
• **Schnee, Daniel
63450 Hanau (DE)**
• **Schwoebel, Andre
63450 Hanau (DE)**

(74) Vertreter: **Heraeus IP
Heraeus Business Solutions GmbH
Intellectual Property
Heraeusstraße 12-14
63450 Hanau (DE)**

(54) **METALL-KERAMIK-SUBSTRAT MIT KONTAKTBEREICH**

(57)     Die Erfindung betrifft ein Metall-Keramik-Substrat, ein elektronisches Bauteil aufweisend ein Metall-Keramik-Substrat und ein Verfahren zur Herstellung eines Metall-Keramik-Substrats. Das Metall-Keramik-Substrat weist auf: a) einen Keramikkörper, der eine Haupterstreckungsebene aufweist, b) eine Metallschicht, die flächig mit dem Keramikkörper verbunden ist, wobei die Metallschicht einen Strukturierungsbereich aufweist, der (i) bereichsweise festes Material und (ii) bereichsweise nicht-festes Material umfasst, und c) einen auf der Metallschicht angeordneten Kontaktbereich aufweisend Silber, wobei in einem Querschnitt durch das Metall-Keramik-Substrat senkrecht zur Haupterstreckungsebene der Strukturierungsbereich eine Geometrie aufweist, wobei folgendes Erfordernis erfüllt ist:

$$S\,(BC_{solid})\,/\,S\,(BC_{total}) > 60\%,$$

wobei: $S\,(BC_{total})$ für die gesamte Länge der Strecke zwischen den Punkten B und C steht und $S\,(BC_{solid})$ für die Länge der Strecke zwischen den Punkten B und C steht, die festes Material schneidet.

Figur 2

**Beschreibung**

Die vorliegende Erfindung betrifft ein Metall-Keramik-Substrat, ein elektronisches Bauteil aufweisend ein Metall-Keramik-Substrat und ein Verfahren zur Herstellung eines Metall-Keramik-Substrats.

Metall-Keramik-Substrate spielen eine wichtige Rolle im Bereich der Leistungselektronik. Sie sind ein maßgebliches Element beim Aufbau von elektronischen Bauteilen und sorgen für eine schnelle Ableitung hoher Wärmemengen beim Betrieb dieser Bauteile. Metall-Keramik-Substrate bestehen üblicherweise aus einer Keramikschicht und einer Metallschicht, die mit der Keramikschicht verbunden ist.

Zur Verbindung der Metallschicht mit der Keramikschicht sind aus dem Stand der Technik mehrere Verfahren bekannt. Beim sogenannten DCB ("Direct Copper Bonding") -Verfahren wird eine Kupferfolie durch Reaktion von Kupfer mit einem Reaktivgas (üblicherweise Sauerstoff) oberflächlich mit einer Kupferverbindung (üblicherweise Kupferoxid) versehen, die einen niedrigeren Schmelzpunkt als Kupfer aufweist. Wenn die so behandelte Kupferfolie auf einen Keramikkörper aufgebracht und der Verbund erhitzt wird, schmilzt die Kupferverbindung und benetzt die Oberfläche des Keramikkörpers, so dass es zu einer stabilen stoffschlüssigen Verbindung zwischen der Kupferfolie und dem Keramikkörper kommt. Dieses Verfahren ist zum Beispiel in der US 3744120 A oder der DE 2319854 C2 beschrieben.

In einem alternativen Verfahren können Metallfolien bei Temperaturen von etwa 650 bis 1000°C mit Keramikkörpern verbunden werden, wobei ein spezielles Lot verwendet wird, das ein Metall mit einem Schmelzpunkt von wenigstens 700°C (üblicherweise Silber) und ein Aktivmetall enthält. Die Rolle des Aktivmetalls besteht darin, mit dem Keramikmaterial zu reagieren und so eine Verbindung des Keramikmaterials mit dem übrigen Lot unter Bildung einer Reaktionsschicht zu ermöglichen, während das Metall mit einem Schmelzpunkt von wenigstens 700°C zur Verbindung dieser Reaktionsschicht mit der Metallfolie dient. So schlägt zum Beispiel die JP4812985 B2 vor, eine Kupferfolie mit einem Keramikkörper unter Verwendung eines Lotes zu verbinden, das 50 bis 89 Gewichtsprozent Silber sowie darüber hinaus Kupfer, Bismut und ein Aktivmetall enthält. Mit diesem Verfahren gelingt es, die Kupferfolie mit dem Keramikkörper zuverlässig zu fügen. Alternativ dazu können auch silberfreie Lote zur Verbindung von Metallfolien mit Keramikkörpern zum Einsatz kommen. Diese Lote basieren zum Beispiel auf hochschmelzenden Metallen (insbesondere Kupfer), niedrigschmelzenden Metallen (wie Bismut, Indium oder Zinn) und Aktivmetallen (wie Titan). Eine solche Technik wird zum Beispiel in der DE 102017114893 A1 vorgeschlagen. Diese Technik führt im Grunde zu einer neuen, eigenständigen Verbindungsklasse, da die Basis der verwendeten Lote durch ein anderes Metall (Kupfer statt Silber) gebildet wird, was zu geänderten Materialeigenschaften führt und eine Anpassung im Hinblick auf die übrigen Lotbestandteile und modifizierte Fügebedingungen zur Folge hat.

Beim Aufbau von elektronischen Bauteilen werden Metall-Keramik-Substrate üblicherweise mit einem Chip bestückt. Für die Bestückung des Metall-Keramik-Substrats mit einem Chip ist es in der Regel erforderlich, dass der mit dem Chip zu bestückende Bereich des Metall-Keramik-Substrats mit einem silberhaltigen Kontaktbereich versehen ist. Durch die Bereitstellung des silberhaltigen Kontaktbereichs wird eine leichtere Anbindung des Chips mit dem Metall-Keramik-Substrat durch gängige Verfahren wie Sintern oder Löten ermöglicht. Zur Schaffung des Kontaktbereichs wird das Metall-Keramik-Substrat in der Regel zunächst bereichsweise mit einer Ätzlösung behandelt, um eine gewünschte Strukturierung auszubilden. Danach wird der Kontaktbereich vorgesehen, indem bereichsweise eine silberhaltige Beschichtung auf der Oberfläche des strukturierten Metall-Keramik-Substrats erzeugt wird.

Die so hergestellten Metall-Keramik-Substrate sind als Teil von elektronischen Bauteilen im Betrieb üblicherweise hohen Temperaturwechseln ausgesetzt. Während in Betriebspausen - je nach Umgebung - die Temperaturen zum Beispiel -20°C oder weniger betragen können, kann die Temperatur der Metall-Keramik-Substrate im Betrieb leicht auf über 150°C ansteigen. Diesen Temperaturunterschieden sind die Metall-Keramik-Substrate regelmäßig wiederholt ausgesetzt. Dabei kann es aufgrund der unterschiedlichen Wärmeausdehnungskoeffizienten des Metalls und der Keramik bei wiederholten Temperaturwechseln zu einer Ablösung der Metallschicht vom Keramikkörper kommen (Peeling), die einen Leistungsausfall zur Folge hat. Damit ist eine hohe Temperaturwechselbeständigkeit ein maßgebliches Kriterium für die Eignung von Metall-Keramik-Substraten für Anwendungen in der Elektronik, insbesondere in der Leistungselektronik.

Wünschenswert wäre es daher, die Temperaturwechselbeständigkeit von Metall-Keramik-Substraten weiter zu erhöhen.

Eine Aufgabe der vorliegenden Erfindung besteht daher darin, ein Metall-Keramik-Substrat zur Verfügung zu stellen, das eine erhöhte Temperaturwechselbeständigkeit aufweist.

Diese Aufgabe wird gelöst durch das Metall-Keramik-Substrat von Anspruch 1. Die Erfindung stellt daher ein Metall-Keramik-Substrat bereit aufweisend

a) einen Keramikkörper, der eine Haupterstreckungsebene aufweist,
b) eine Metallschicht, die flächig mit dem Keramikkörper verbunden ist, wobei die Metallschicht einen Strukturierungsbereich aufweist, der

(i) bereichsweise festes Material und
(ii) bereichsweise nicht-festes Material

umfasst, und

c) einen auf der Metallschicht angeordneten Kontaktbereich aufweisend Silber, dadurch gekennzeichnet, dass in einem Querschnitt durch das Metall-Keramik-Substrat senkrecht zur Haupterstreckungsebene der Strukturierungsbereich eine Geometrie aufweist, wobei folgendes Erfordernis erfüllt ist:

$$S\,(BC_{solid})\,/\,S\,(BC_{total}) > 60\%,$$

wobei:
$S\,(BC_{total})$ für die gesamte Länge der Strecke zwischen den Punkten B und C steht und $S\,(BC_{solid})$ für die Länge der Strecke zwischen den Punkten B und C steht, die festes Material schneidet,
wobei die Punkte B und C wie folgt bestimmt werden:

1. die Ausgleichsgerade zwischen dem Keramikkörper und der Metallschicht wird bestimmt;
2. die Konturlinie wird bestimmt, die das feste Material vom nicht-festen Material trennt;
3. auf einer Senkrechten zur Ausgleichsgeraden wird im Abstand von 150 $\mu$m zur Ausgleichsgeraden der Punkt A ermittelt, in dem die Senkrechte zur Ausgleichsgeraden die Konturlinie schneidet;
4. auf einer Senkrechten zur Ausgleichsgeraden wird im Abstand von 80 $\mu$m zur Ausgleichsgeraden der Punkt B ermittelt, in dem die Senkrechte zur Ausgleichsgeraden die Konturlinie schneidet;
5. auf einer Geraden, die durch die Punkte A und B verläuft, wird der Punkt C ermittelt, in dem die Gerade die Ausgleichsgeraden schneidet.

Ferner betrifft die Erfindung ein elektronisches Bauteil aufweisend ein solches Metall-Keramik-Substrat und einen Chip.

Außerdem betrifft die Erfindung ein Verfahren zur Herstellung eines Metall-Keramik-Substrats.

Das erfindungsgemäße Metall-Keramik-Substrat umfasst einen Keramikkörper, der eine Haupterstreckungsebene aufweist.

Der Keramikkörper ist vorzugsweise ein Körper, der aus Keramik gebildet ist. Der Körper kann eine beliebige Geometrie einnehmen, ist aber vorzugsweise als Quader ausgestaltet. Der Keramikkörper weist Begrenzungsflächen auf, im Falle eines Quaders sechs Begrenzungsflächen. Als Hauptbegrenzungsfläche wird hierin vorzugsweise die Begrenzungsfläche mit dem größten Flächeninhalt bezeichnet, die mit der Metallschicht flächig verbunden ist. Die Hauptbegrenzungsfläche liegt vorzugsweise in der Haupterstreckungsebene oder verläuft parallel zu dieser. Demnach wird unter Haupterstreckungsebene des Keramikkörpers vorzugsweise eine Ebene verstanden, die parallel zur Hauptbegrenzungsfläche des Keramikkörpers verläuft oder diese umschließt.

Die Keramik des Keramikkörpers ist vorzugsweise eine isolierende Keramik. Gemäß einer bevorzugten Ausführungsform ist die Keramik aus der Gruppe ausgewählt, die aus Oxidkeramiken, Nitridkeramiken und Carbidkeramiken besteht. Gemäß einer weiteren bevorzugten Ausführungsform ist die Keramik aus der Gruppe ausgewählt, die aus Metalloxidkeramiken, Siliziumoxidkeramiken, Metallnitridkeramiken, Siliziumnitridkeramiken, Bornitridkeramiken und Borcarbidkeramiken besteht. Gemäß einer besonders bevorzugten Ausführungsform ist die Keramik aus der Gruppe ausgewählt, die aus Aluminiumnitridkeramiken, Siluziumnitridkeramiken und Aluminiumoxidkeramiken (wie zum Beispiel ZTA ("Zirconia Toughened Alumina") -Keramiken) besteht. Gemäß einer weiteren ganz besonders bevorzugten Ausführungsform besteht der Keramikkörper aus (1) wenigstens einem Element, das aus der Gruppe ausgewählt ist, die aus Silizium und Aluminium besteht, (2) wenigstens einem Element, das aus der Gruppe ausgewählt ist, die aus Sauerstoff und Stickstoff besteht, optional (3) wenigstens einem Element, das aus der Gruppe ausgewählt ist, die aus (3a) Metallen der seltenen Erden, (3b) Metallen der zweiten Hauptgruppe des Periodensystems der Elemente, (3c) Zirkonium, (3d) Kupfer, (3e) Molybdän und (3f) Silizium besteht, und optional (4) unvermeidlichen Verunreinigungen. Gemäß noch einer weiteren ganz besonders bevorzugten Ausführungsform ist der Keramikkörper frei von Bismut, Gallium und Zink.

Der Keramikkörper weist vorzugsweise eine Dicke von 0,05 - 10 mm, mehr bevorzugt im Bereich von 0,1 - 5 mm und besonders bevorzugt im Bereich von 0,15 - 3 mm auf.

Das erfindungsgemäße Metall-Keramik-Substrat umfasst eine Metallschicht, die flächig mit dem Keramikkörper verbunden ist, wobei die Metallschicht einen Strukturierungsbereich aufweist, der (i) bereichsweise festes Material und (ii) bereichsweise nicht-festes Material umfasst.

Die Metallschicht ist mit dem Keramikkörper vorzugsweise stoffschlüssig verbunden. Gemäß einer bevorzugten Ausführungsform ist die Metallschicht mit dem Keramikkörper über ein DCB (Direct Copper Bonding) -Verfahren verbunden. Gemäß einer weiteren bevorzugten Ausführungsform ist die Metallschicht mit dem Keramikkörper über ein Hartlotverfahren verbunden. Bei dem Hartlotverfahren kann es sich zum Beispiel um ein AMB (Active Metal Brazing) -Verfahren handeln, wobei vorzugsweise silberfreie Hartlote (der Gehalt an Silber beträgt dann zum Beispiel weniger als 1,0 Gewichtsprozent basierend auf dem Feststoffgehalt des Hartlotes) oder silberhaltige Hartlote (der Gehalt an Silber beträgt dann zum Beispiel wenigstens 50 Gewichtsprozent basierend auf dem Feststoffgehalt des Hartlotes) verwendet werden. Folglich kann die Metallschicht auch eine Verbindungsschicht umfassen, die mit dem Keramikkörper in Kontakt steht. Bei der Verbindungsschicht kann es sich zum Beispiel um eine Lotschicht (insbesondere eine Hartlotschicht) oder eine Diffusionsschicht handeln.

Die Metallschicht ist mit dem Keramikkörper flächig verbunden. Dementsprechend ist die Metallschicht flächig vorzugsweise mit der Hauptbegrenzungsfläche des Keramikkörpers verbunden. Die Metallschicht ist vorzugsweise nicht mit der gesamten Hauptbegrenzungsfläche des Keramikkörpers verbunden. Insbesondere kann es vorgesehen sein, dass die Hauptbegrenzungsfläche des Keramikkörpers größer ist als die Fläche der mit dem Keramikkörper verbundenen Metallschicht. In diesen Fällen steht die Hauptbegrenzungsfläche des Keramikkörpers über. Darüber hinaus ist die Metallschicht vorzugsweise strukturiert. Unter Strukturierungen werden vorzugsweise Ausnehmungen in der Metallschicht verstanden, um einzelne Abschnitte der Metallschicht voneinander zu trennen und damit elektrisch zu isolieren. Derartige Strukturierungen werden üblicherweise durch Ätztechniken erzeugt.

Dementsprechend weist die Metallschicht einen Strukturierungsbereich auf. Unter Strukturierungsbereich wird ein Abschnitt der Metallschicht verstanden, der eine Strukturierung enthält. Bei einer Strukturierung handelt es sich vorzugsweise um eine Ausnehmung in der Metallschicht.

Die Metallschicht weist auf der (vorzugsweise der Hauptbegrenzungsfläche des Keramikkörpers abgewandten) Oberseite ferner eine zur Hauptbegrenzungsfläche des Keramikkörpers parallele Metallhauptfläche auf. Diese Metallhauptfläche umfasst daher Metall der Metallschicht, das im Strukturierungsbereich von der Ausnehmung unterbrochen ist.

Der Strukturierungsbereich weist einen Bereich, der festes Material umfasst, und einen Bereich, der nicht- festes Material umfasst, auf.

Der Bereich, der festes Material umfasst, enthält vorzugsweise wenigstens ein Mitglied aus der Gruppe bestehend aus (i) Metall der Metallschicht (gegebenenfalls einschließlich einer Verbindungsschicht (soweit vorhanden, zum Beispiel im Fall von AMBs), (ii) Metall des Kontaktbereichs (insbesondere Silber) und (iii) Material des Keramikkörpers. Daher enthält das feste Material vorzugsweise (i) Metall der Metallschicht (gegebenenfalls einschließlich einer Verbindungsschicht) und optional (ii) Metall des Kontaktbereichs (insbesondere Silber) und/oder (iii) Material des Keramikkörpers.

Gemäß einer bevorzugten Ausführungsform umfasst der Strukturierungsbereich zwischen der Metallhauptfläche (ausgenommen des Kontaktbereichs) und der Hauptbegrenzungsfläche des Keramikkörpers nicht das Hauptmetall des Kontaktbereichs, insbesondere kein Silber. Gemäß einer weiteren bevorzugten Ausführungsform weist das feste Material des Strukturierungsbereichs zwischen der Metallhauptfläche (ausgenommen des Kontaktbereichs) und der Hauptbegrenzungsfläche des Keramikkörpers keine Abscheidung des Hauptmetalls des Kontaktbereichs, insbesondere von Silber, auf. Dementsprechend weist gemäß einer besonders bevorzugten Ausführungsform das feste Material des Strukturierungsbereichs zwischen der Metallhauptfläche (ausgenommen des Kontaktbereichs) und der Hauptbegrenzungsfläche des Keramikkörpers keine Schicht aus dem Hauptmetall des Kontaktbereichs, insbesondere aus Silber, auf. Als Hauptmetall des Kontaktbereichs wird vorzugsweise das Metall bezeichnet, das im Kontaktbereich den höchsten Gewichtsanteil aufweist.

Der Bereich, der nicht-festes Material umfasst, enthält vorzugsweise gasförmiges Material. Daher umfasst das nicht-feste Material vorzugsweise gasförmiges Material. Das nicht-feste Material ist vorzugsweise gasförmiges Material, mit der die Ausnehmung in der Metallschicht befüllt ist. Dieses gasförmige Material stammt üblicherweise aus der Umgebungsatmosphäre. Vorzugsweise enthält das gasförmige Material daher wenigstens ein Element, das aus der Gruppe ausgewählt ist, die aus Stickstoff, Sauerstoff und Edelgasen besteht. Ganz bevorzugt handelt es sich bei dem gasförmigen Material um Luft.

Gemäß einer bevorzugten Ausführungsform erstreckt sich die Ausnehmung in einer Richtung senkrecht zur Hauptbegrenzungsfläche des Keramikkörpers von der Hauptbegrenzungsfläche des Keramikkörpers bis zur Metallhauptfläche. Die Ausnehmung bildet dabei vorzugsweise einen Kanal aus, der zu wenigstens 50 Volumenprozent, mehr bevorzugt zu wenigstens 80 Volumenprozent, noch mehr bevorzugt zu wenigstens 90 Volumenprozent, besonders bevorzugt zu wenigstens 95 Volumenprozent und ganz besonders bevorzugt zu wenigstens 99 Volumenprozent, insbesondere vollständig, mit nicht-festem Material befüllt ist.

Die Metallschicht umfasst vorzugsweise wenigstens ein Metall, das aus der Gruppe ausgewählt, die aus Kupfer, Aluminium und Molybdän besteht. Gemäß einer besonders bevorzugten Ausführungsform umfasst die Metallschicht wenigstens ein Metall, das aus der Gruppe ausgewählt, die aus Kupfer und Molybdän besteht. Gemäß einer ganz besonders bevorzugten Ausführungsform umfasst die Metallschicht Kupfer. Gemäß einer weiteren bevorzugten Ausführungsform besteht die Metallschicht aus Kupfer und unvermeidlichen Verunreinigungen. Gemäß einer weiteren bevorzugten Ausführungsform beträgt der Anteil an Kupfer wenigstens 60 Gewichtsprozent, mehr bevorzugt wenigstens 65 Gewichtsprozent, noch mehr bevorzugt wenigstens 70 Gewichtsprozent und besonders bevorzugt wenigstens 75 Gewichtsprozent, bezogen auf das Gesamtgewicht der Metallschicht (vorzugsweise einschließlich einer gegebenenfalls enthaltenen Verbindungsschicht).

Gemäß einer bevorzugten Ausführungsform wird die Metallschicht erzeugt, indem eine Kupferfolie (vorzugsweise eine Folie aus hochreinem Kupfer) mit einem Keramikkörper stoffschlüssig verbunden wird. Gemäß einer bevorzugten Ausführungsform kann die Verbindung über ein DCB (Direct Copper Bonding) -Verfahren oder über ein Hartlotverfahren erfolgen. Bei dem Hartlotverfahren kann es sich zum Beispiel um ein AMB (Active Metal Brazing) -Verfahren handeln, wobei vorzugsweise silberfreie Hartlote (der Gehalt an Silber beträgt dann zum Beispiel weniger als 1,0 Gewichtsprozent basierend auf dem Feststoffgehalt des Hartlotes) oder silberhaltige Hartlote (der Gehalt an Silber beträgt dann zum Beispiel wenigstens 50 Gewichtsprozent basierend auf dem Feststoffgehalt des Hartlotes) verwendet werden. In diesem Fall kann die Metallschicht neben dem aus der Kupferfolie stammenden Kupfer auch Metalle einer Verbindungsschicht umfassen, insbesondere Metalle einer Lotschicht (zum Beispiel einer Hartlotschicht) oder einer Diffusionsschicht.

Die Metallschicht weist vorzugsweise eine Dicke im Bereich von 0,01 - 10 mm, besonders bevorzugt im Bereich von 0,03 - 5 mm und ganz besonders bevorzugt im Bereich von 0,05 - 3 mm auf.

Das erfindungsgemäße Metall-Keramik-Substrat weist einen auf der Metallschicht angeordneten Kontaktbereich aufweisend Silber auf. Der Kontaktbereich dient vorzugsweise dazu, die Anbindung eines Halbleiters auf der Metallschicht zu erleichtern. Halbleiter werden vorzugsweise durch Sintern, Löten oder Kleben mit der Metallschicht verbunden. Da insbesondere das Befestigen von Halbleitern auf dem Metall der Metallschicht eines Metall-Keramik-Substrats nicht ohne weiteres möglich ist, wird die Metallschicht vorzugsweise mit einem Kontaktbereich versehen. Der Kontaktbereich besteht vorzugsweise aus Silber oder einer silberhaltigen Legierung. Im Fall einer silberhaltigen Legierung enthält diese wenigstens 50 Gewichtsprozent Silber, bezogen auf das Gewicht der Silberlegierung. Vorzugsweise ist ein Kontaktbereich auf der Metallschicht des Metall-Keramik-Substrats an allen Positionen vorgesehen, wo später eine Bestückung des Metall-Keramik-Substrats mit Halbleitern erfolgen soll. Der Kontaktbereich kann auf der Metallschicht des Metall-Keramik-Substrats durch unterschiedliche Techniken ausgebildet sein. Beispielsweise ist es möglich, den Kontaktbereich durch Abscheidung vorzusehen. Bei der Abscheidung kann es sich zum Beispiel um eine physikalische Abscheidung oder eine chemische Abscheidung handeln. Als physikalische Abscheidung kommt beispielsweise die Gasphasenabscheidung in Betracht. Bevorzugte Verfahren zur Gasphasenabscheidung sind dabei insbesondere die Elektronenstrahlabscheidung, die Laserstrahlabscheidung, die Bogenentladungsabscheidung oder das Kathodenzerstäuben. Bei der chemischen Abscheidung wird der Kontaktbereich vorzugsweise dadurch erzeugt, dass auf die Metallschicht eine Zusammensetzung aufgebracht wird, die Silber oder einen Silbervorläufer enthält. Eine Zusammensetzung, die Silber enthält, kann beispielsweise gebrannt werden, um eine Sinterverbindung des in der Zusammensetzung enthaltenen Silbers mit dem Metall der Metallschicht zu erzeugen. Eine Zusammensetzung, die einen Silbervorläufer enthält, kann zum Beispiel einer Behandlung unterzogen werden, die Silber freisetzt und eine Adsorption des Silbers an der Metallschicht ermöglicht. Diese Behandlung kann zum Beispiel durch Kontaktierung des Silbervorläufers mit der Metallschicht erfolgen. Verfahren zur Abscheidung von Silber oder Silberverbindungen zur Erzeugung von Kontaktbereichen auf der Metallschicht von Metall-Keramik-Substraten sind dem Fachmann bekannt.

Der Strukturierungsbereich der Metallschicht weist in einem Querschnitt durch das Metall-Keramik-Substrat senkrecht zur Haupterstreckungsebene eine Geometrie auf, wobei folgendes Erfordernis erfüllt ist:

$$S\ (BC_{solid})\ /\ S\ (BC_{total}) > 60\%,$$

wobei:

S ($BC_{total}$) für die gesamte Länge der Strecke zwischen den Punkten B und C steht und
S ($BC_{solid}$) für die Länge der Strecke zwischen den Punkten B und C steht, die festes Material schneidet.

Gemäß einer bevorzugten Ausführungsform weist der Strukturierungsbereich der Metallschicht in einem Querschnitt durch das Metall-Keramik-Substrat senkrecht zur Haupterstreckungsebene eine Geometrie auf, wobei das Verhältnis S ($BC_{solid}$) / S ($BC_{total}$) > 70% ist, mehr bevorzugt > 80% ist, noch mehr bevorzugt > 85% ist, besonders bevorzugt > 90% ist und ganz besonders bevorzugt > 95% ist.

Gemäß einer weiteren bevorzugten Ausführungsform weist der Strukturierungsbereich der Metallschicht in einem Querschnitt durch das Metall-Keramik-Substrat senkrecht zur Haupterstreckungsebene eine Geometrie auf, wobei das Verhältnis S ($BC_{solid}$) / S ($BC_{total}$) im Bereich von 70 - 100%, besonders bevorzugt im Bereich von 80 - 100% und ganz besonders bevorzugt im Bereich von 80 - 99%, liegt.

Zur Bestimmung der Punkte B und C wird ein Querschnitt des Strukturierungsbereichs der Metallschicht des Metall-Keramik-Substrats beobachtet. Der Querschnitt verläuft senkrecht zur Haupterstreckungsebene des Keramikkörpers. Vorzugsweise kann die Beobachtung des Querschnitts erfolgen, indem das Metall-Keramik-Substrat senkrecht zur Haupterstreckungsebene des Keramikkörpers geschnitten und eine Aufnahme des so erhaltenen Querschnitts durch ein Lichtmikroskop angefertigt wird.

Die Punkte B und C der Strecke BC können dabei im Querschnitt wie nachstehend beschrieben bestimmt werden.

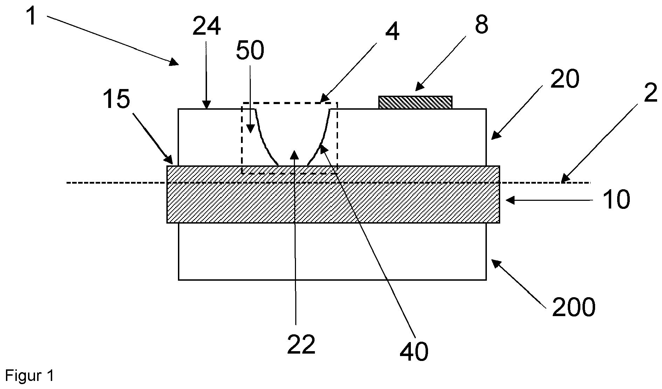

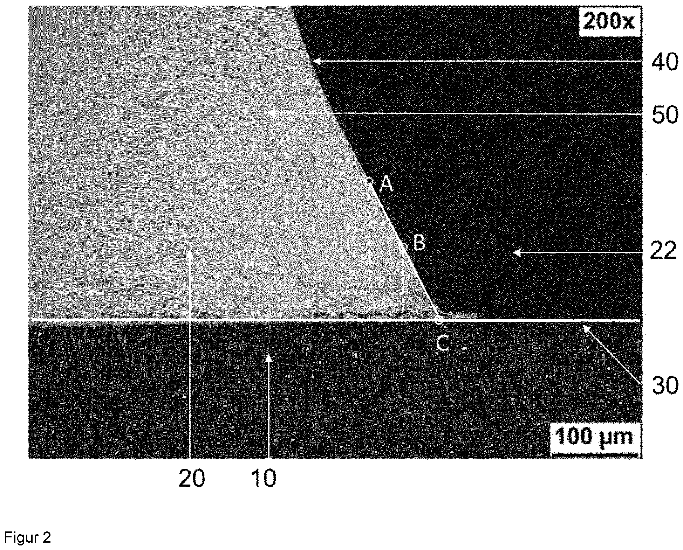

Zur Veranschaulichung wird beispielhaft auf die Figuren 1 und 2 Bezug genommen.

Figur 1 zeigt schematisch ein gattungsgemäßes Metall-Keramik-Substrat.

Figur 2 zeigt einen Teil eines Querschnitts durch ein erfindungsgemäßes Metall-Keramik-Substrat.

Das in Figur 1 gezeigte Metall-Keramik-Substrat 1 weist einen Keramikkörper 10 auf. Eine Haupterstreckungsebene 2 des Keramikkörper 10 ist (als Linie) mit dem Bezugszeichen 2 angedeutet. Der Keramikkörper 10 weist eine Hauptbegrenzungsfläche 15 auf. Das Metall-Keramik-Substrat 1 weist eine Metallschicht 20 auf, die flächig mit der Hauptbegrenzungsfläche 15 des Keramikkörpers 10 verbunden ist. Das Metall-Keramik-Substrat 1 weist in der Ausführungsform gemäß Figur 1 ferner eine weitere Metallschicht 200 auf, die flächig mit dem Keramikkörper 10 verbunden ist. Auf der Metallschicht 20 befindet sich ein Kontaktbereich 8 aufweisend Silber. Die Metallschicht 20 weist eine Strukturierung auf. Diese ist durch eine Ausnehmung 22 in der Metallschicht 20 gebildet. Die Ausnehmung 22 enthält nicht-festes Material. Der Strukturierungsbereich 4 umfasst bereichsweise die Metallschicht 20 und die Ausnehmung 22. Daher umfasst der Strukturierungsbereich 4 bereichsweise festes Material 50, das durch das Metall der Metallschicht 20 gebildet ist, und nicht-festes Material (zum Beispiel gasförmiges Material), mit der die Ausnehmung 22 befüllt ist. Das gasförmige Material ist üblicherweise Umgebungsluft. Das feste Material 50 ist vom nicht-festen Material der Ausnehmung 22 durch eine Konturlinie 40 getrennt. Die Metallschicht 20 weist auf der Oberseite, die der Hauptbegrenzungsfläche 15 der Keramik abgewandt ist, eine zur Hauptbegrenzungsfläche 15 der Keramik parallele Metallhauptfläche 24 auf. Diese Metallhauptfläche 24 umfasst Metall der Metallschicht 20, das im Strukturierungsbereich von der Ausnehmung 22 unterbrochen ist. Die Ausnehmung 22 erstreckt sich in einer Richtung senkrecht zur Hauptbegrenzungsfläche 15 der Keramik von der Hauptbegrenzungsfläche 15 der Keramik bis zur Metallhauptfläche 24 und bildet dabei vorzugsweise einen Kanal aus, der vollständig oder überwiegend mit nicht festem-Material befüllt ist.

In dem Teil eines Querschnitts durch ein erfindungsgemäßes Metall-Keramik-Substrat, der in Figur 2 gezeigt ist, ist ein Abschnitt eines Strukturierungsbereichs zu sehen. Dargestellt sind ein Bereich des Keramikkörpers 10, der flächig mit einem Bereich einer Metallschicht 20 verbunden ist. Die Konturlinie 40 trennt das feste Material 50 vom nicht-festen Material der Ausnehmung 22 in der Metallschicht 20.

Die Bestimmung der Punkte B und C der Strecke BC im Querschnitt erfolgt vorzugsweise in mehreren Schritten: In einem ersten Schritt wird die die Ausgleichsgerade 30 zwischen dem Keramikkörper 10 und der Metallschicht 20 bestimmt. Dazu wird optisch der Bereich des Keramikkörpers 10 und der Bereich der Metallschicht 20 ermittelt und die Ausgleichsgerade 30 als die im Querschnitt beobachtbare Grenze zwischen dem Keramikkörper 10 und der Metallschicht 20 festgelegt.

In einem zweiten Schritt wird die Konturlinie 40 bestimmt, die das feste Material 50 vom nicht-festen Material der Ausnehmung 22 trennt. Das feste Material 50 wird optisch bestimmt; dabei handelt es sich üblicherweise um das Material der Metallschicht 20. Das nicht-feste Material wird ebenfalls optisch bestimmt. Bei dem nicht-festen Material handelt es sich üblicherweise um gasförmiges Material, mit dem die Strukturierung als Ausnehmung 22 in der Metallschicht 20 befüllt ist.

In einem dritten Schritt wird auf einer Senkrechten zur Ausgleichsgeraden 30 im Abstand von 150 $\mu$m zur Ausgleichsgeraden 30 der Punkt A ermittelt, in dem die Senkrechte zur Ausgleichsgeraden 30 die Konturlinie 40 schneidet.

In einem vierten Schritt wird auf einer Senkrechten zur Ausgleichsgeraden 30 im Abstand von 80 $\mu$m zur Ausgleichsgeraden 30 der Punkt B ermittelt, in dem die Senkrechte zur Ausgleichsgeraden 30 die Konturlinie 40 schneidet.

In einem fünften Schritt wird auf einer Geraden, die durch die Punkte A und B verläuft, der Punkt C ermittelt, in dem die Gerade die Ausgleichsgerade 30 schneidet.

Der Schnitt des Metall-Keramik-Substrats senkrecht zur Haupterstreckungsebene des Keramikkörpers und die Aufnahme des so erhaltenen Querschnitts durch ein Lichtmikroskop (Auflicht/Hellfeld) erfolgen vorzugsweise wie nachstehend beschrieben:

In einem ersten Schritt wird aus dem zu untersuchenden Metall-Keramik-Substrat zunächst durch Sägen mit einem Diamantsägeblatt bei niedriger Drehzahl und unter Verwendung eines Schmiermittels (Exakt) senkrecht zu einer durch die von der Metallhauptfläche der Metallschicht des Metall-Keramik-Substrats aufgespannten Ebene ein quaderförmiger Probenrohling mit einer rechteckigen Grundfläche im Bereich von 100 mm² bis 400 mm² ausgeschnitten. Der Probenrohling weist demnach eine Probenoberfläche auf, die der Untersuchung zugeführt wird. Diese Probenoberfläche verläuft mithin senkrecht zu der vor dem Sägen durch die von der Metallhauptfläche der Metallschicht des Metall-Keramik-Substrats aufgespannten Ebene. Sie weist daher Anteile an dem Keramikkörper und der Metallschicht (einschließlich der gegebenenfalls vorhandenen Verbindungsschicht) auf. Der Probenrohling wird zunächst in einer Gussform mit einem Epoxidharz mit geringer Schrumpfung (Caldo-Fix, Struers) eingebettet, wobei die Probenoberfläche senkrecht zur Formwand orientiert ist. Anschließend wird das Epoxidharz bei 75°C im Trockenschrank ausgehärtet. Nach der Aushärtung wird die Probenoberfläche des Probenrohlings mit einer automatisierten Poliervorrichtung (Tegrapol, Struers) mechanisch poliert, um eine Rauigkeit von 1 μm oder weniger zu erreichen.

In einem zweiten Schritt wird mittels Lichtmikroskop (Leica, DM6000M, Auflicht/Hellfeld) bei einer Vergrößerung von 200x in der Analysezone ein Strukturierungsbereich in der Metallschicht identifiziert, der bereichsweise festes Material und bereichsweise nicht-festes Material umfasst. Festes Material und nicht-festes Material können in dem Strukturierungsbereich aufgrund der unterschiedlichen Farbgebung eindeutig unterschieden werden.

Die Längen der Strecken S (BC$_{total}$) und S (BC$_{solid}$) werden vorzugsweise auf fachübliche Weise bestimmt, so zum Beispiel unter Verwendung einer Bildauswertungssoftware (zum Beispiel IMS Client, Imagic).

Vorzugsweise bezieht sich der Begriff "in einem Querschnitt", wie hierin verwendet, auf eine (vorzugsweise repräsentative) Gesamtheit von Querschnitten, besonders bevorzugt auf wenigstens zehn Querschnitte, ganz besonders bevorzugt auf nicht mehr als 20 Querschnitte und insbesondere zehn Querschnitte. Die Querschnitte verlaufen vorzugsweise parallel zueinander und sind gleichmäßig voneinander beabstandet. Dabei wird zur Ermittlung des Verhältnisses S (BC$_{solid}$) / S (BC$_{total}$) für ein zu beobachtendes Metall-Keramik-Substrat vorzugsweise wie folgt vorgegangen:

1. Es werden wenigstens zehn, besonders bevorzugt zehn, unterschiedliche Querschnitte des Strukturierungsbereichs untersucht;

2. es wird das Verhältnis S (BC$_{solid}$) / S (BC$_{total}$) für jeden dieser Querschnitte bestimmt; und

3. es wird der Mittelwert aus den Verhältnissen S (BC$_{solid}$) / S (BC$_{total}$) für jeden dieser Querschnitte gebildet, um zum Verhältnis S (BC$_{solid}$) / S (BC$_{total}$) für das zu beobachtende Metall-Keramik-Substrat zu gelangen.

Gemäß einer bevorzugten Ausführungsform beträgt die Stichprobenstandardabweichung SSD des Verhältnisses S (BC$_{solid}$) / S (BC$_{total}$) über wenigstens zehn unterschiedliche Querschnitte des Strukturierungsbereichs der Metallschicht, mehr bevorzugt über nicht mehr als 20 unterschiedliche Querschnitte des Strukturierungsbereichs der Metallschicht, und ganz besonders bevorzugt über zehn unterschiedliche Querschnitte des Strukturierungsbereichs der Metallschicht, nicht mehr als 10%, mehr bevorzugt nicht mehr als 7%, besonders bevorzugt nicht mehr als 5% und ganz besonders bevorzugt nicht mehr als 3%. Die Stichprobenstandardabweichung SSD wird dabei nach folgender Formel ermittelt:

$$\mathrm{SSD} = \sqrt{\frac{1}{n-1} \sum_{i=1}^{n} \left( X_i - \overline{X} \right)^2},$$

wobei:

$n$ = Anzahl der Einzelwerte für das Verhältnis S (BC$_{solid}$) / S (BC$_{total}$),
$X_i$ = Einzelwert für das Verhältnis S (BC$_{solid}$) / S (BC$_{total}$) und
$\overline{X}$ = Mittelwert aus den Einzelwerten für das Verhältnis S (BC$_{solid}$) / S (BC$_{total}$).

Überraschenderweise wurde festgestellt, dass Metall-Keramik-Substrate mit der erfindungsgemäßen Geometrie eine erhöhte Temperaturwechselbeständigkeit gegenüber Metall-Keramik-Substraten aus dem Stand der Technik aufweisen. Diese Metall-Keramik-Substrate weisen in der Metallschicht an der Grenze zur Oberfläche des Keramikkörpers einen hohen Anteil an festem Material auf. Im Gegensatz dazu wurde festgestellt, dass der Anteil an festem Material in der Metallschicht an der Grenze zur Oberfläche des Keramikkörpers bei Metall-Keramik-Substraten aus dem Stand der Technik, soweit diese einen auf der Metallschicht angeordneten Kontaktbereich aufweisend Silber aufweisen, deutlich geringer ist.

Ohne an eine Erklärung gebunden zu sein, könnte dies darauf zurückzuführen sein, dass im Stand der Technik das hergestellte Metall-Keramik-Substrat üblicherweise zunächst strukturiert und im Anschluss zur Schaffung des Kontaktbereichs oberflächlich versilbert wird. Die Versilberung erfolgt üblicherweise dadurch, dass das strukturierte Metall-Keramik-Substrat in ein Bad mit einer silberionenhaltigen Lösung getaucht wird. Dabei werden elektrochemisch Metallionen aus der Metallschicht des Metall-Keramik-Substrats herausgelöst und durch Silberionen ersetzt. Im Rahmen der Erfindung wurde beobachtet, dass bei diesem Prozess Silberionen überwiegend an der Oberfläche des Metall-Keramik-Substrats abgeschieden, dabei aber die Metallionen der Metallschicht überwiegend in einem Bereich in der Nähe des Keramikkörpers herausgelöst werden (ein Effekt, der sich durch eine Maskierung der Strukturierung nicht verhindern lässt, da die Maskierung aufgrund von randseitigen Strukturierungen in der Metallschicht von der silberionenhaltigen Lösung unterspült werden). Dieser Effekt ist besonders ausgeprägt, wenn die Metallschicht in dem an den Keramikkörper angrenzenden Bereich bereits strukturiert und daher nicht mehr homogen ist. Dadurch kommt es zu einer Abtragung von festem Material - insbesondere des Metalls der Metallfolie - aus der Metallfolie im Bereich nahe des Keramikkörpers und somit zur Schaffung einer Schwachstelle für die Ablösung der Metallschicht vom Keramikkörper, was sich nachteilig auf die Temperaturwechselbeständigkeit auswirkt. Erfindungsgemäß wird dagegen ein Strukturierungsbereich geschaffen, der ausreichende Mengen von festem Material im Bereich nahe des Keramikkörpers aufweist, wodurch eine Ablösung der Metallschicht vom Keramikkörper verhindert und eine Verbesserung der Temperaturwechselbeständigkeit erreicht werden kann.

Gemäß einer bevorzugten Ausführungsform umfasst das Metall-Keramik-Substrat eine weitere (zweite) Metallschicht, die flächig mit dem Keramikkörper verbunden ist. Die weitere Metallschicht ist vorzugsweise mit der der Hauptbegrenzungsfläche der Keramik abgewandten (und vorzugsweise zu dieser parallel verlaufenden) Begrenzungsfläche flächig verbunden. Die weitere (zweite) Metallschicht kann wie die (erste) Metallschicht beschaffen sein oder in ihrer Beschaffenheit von der (ersten) Metallschicht abweichen. Zur Beschaffenheit der weiteren (zweiten) Metallschicht wird auf die vorstehenden Erläuterungen Bezug genommen.

Das erfindungsgemäße Metall-Keramik-Substrat kann insbesondere für Anwendungen in der Elektronik, vor allem für den Bereich der Leistungselektronik, eingesetzt werden.

Die Erfindung stellt daher auch ein elektronisches Bauteil bereit, das ein vorstehend beschriebenes Metall-Keramik-Substrat aufweist.

Gemäß einer bevorzugten Ausführungsform umfasst ein solches elektronisches Bauteil eine Bodenplatte. Diese Bodenplatte ist vorzugsweise mit der Metallschicht des Metall-Keramik-Substrats flächig verbunden. Alternativ kann die Metallschicht des Metall-Keramik-Substrats als Kühlkörper ausgebildet sein. Gemäß einer weiteren bevorzugten Ausführungsform umfasst das elektronische Bauteil wenigstens einen Chip. Der wenigstens eine Chip ist vorzugsweise flächig mit dem auf der Metallschicht angeordneten Kontaktbereich aufweisend Silber verbunden. Gemäß einer weiteren bevorzugten Ausführungsform umfasst das elektronische Bauteil ein Metall-Keramik-Substrat, das eine erste Metallschicht und eine zweite Metallschicht aufweist (wobei die erste Metallschicht der zweiten Metallschicht vorzugsweise gegenüber liegt), eine Bodenplatte und wenigstens einen Chip, wobei der wenigstens eine Chip mit der ersten Metallschicht des Metall-Keramik-Substrats über den auf der Metallschicht angeordneten Kontaktbereich aufweisend Silber und die Bodenplatte mit der zweiten Metallschicht des Metall-Keramik-Substrats verbunden ist.

Das erfindungsgemäße Metall-Keramik-Substrat kann durch unterschiedliche Herstellverfahren erhalten werden.

Gemäß einer bevorzugten Ausführungsform handelt es sich bei dem Verfahren um ein Verfahren zur Herstellung eines Metall-Keramik-Substrats, das mit einer Strukturierung und einem Kontaktbereich aufweisend Silber versehen ist, umfassend die Schritte:

a) Bereitstellung eines Metall-Keramik-Substrats aufweisend

a1) einen Keramikkörper und
a2) eine mit dem Keramikkörper flächig verbundene Metallschicht,

b) Aufbringen einer ersten Maskierung auf der Metallschicht,
c) Abscheiden einer silberhaltigen Schicht auf den unmaskierten Bereichen der Metallschicht unter Erhalt eines Kontaktbereichs aufweisend Silber,
d) Entfernen der ersten Maskierung,
e) Aufbringen einer zweiten Maskierung auf der Metallschicht,
f) Ätzen von unmaskierten Bereichen der Metallschicht unter Erhalt einer Strukturierung und
g) Entfernen der zweiten Maskierung.

In diesem Verfahren wird daher vorzugsweise zunächst ein Metall-Keramik-Substrat bereitgestellt. Dieses Metall-Keramik-Substrat weist einen Keramikkörper und eine mit dem Keramikkörper flächig verbundene Metallschicht auf. Bei dem Metall-Keramik-Substrat kann es sich um ein fachübliches Metall-Keramik-Substrat handeln. Der Keramikkörper und die Metallschicht können eine Zusammensetzung aufweisen, wie sie vorstehend in Bezug auf das Metall-Keramik-Substrat beschrieben ist. Die Metallschicht kann mit dem Keramikkörper vorzugsweise stoffschlüssig verbunden sein, wie dies ebenfalls vorstehend in Bezug auf das Metall-Keramik-Substrat beschrieben ist.

In dem Verfahren wird vorzugsweise auf die Metallschicht eine erste Maskierung aufgebracht. Die erste Maskierung dient dazu, die maskierten Bereiche der Metallschicht im darauffolgenden Schritt vor einer Abscheidung einer silberhaltigen Schicht zu schützen. Dies stellt sicher, dass eine Abscheidung einer silberhaltigen Schicht nur auf die unmaskierten Bereiche der Metallschicht des Metall-Keramik-Substrats erfolgt. Folglich ist die Maskierung so beschaffen, dass kein Abscheiden einer silberhaltigen Schicht auf die maskierten Bereiche der Metallschicht des Metall-Keramik-Substrats erfolgt. Die Art der Maskierung ist nicht weiter eingeschränkt. Bei der Maskierung kann es sich beispielsweise um eine fachübliche Negativmaske oder Positivmaske handeln. Die Maskierung kann beispielsweise durch eine Folie (beziehungsweise einen Trockenfilm) oder eine Flüssigkeit, die gegebenenfalls bereichsweise auf die Oberfläche des Metall-Keramik-Substrats gedruckt oder gesprüht wird, erzeugt werden. Dabei können zum Beispiel fachübliche Ätzresists zum Einsatz kommen. Diese Ätzresists enthalten vorzugsweise ein härtbares Polymer (zum Beispiel ein lichthärtbares Polymer). Gemäß einer möglichen Ausführungsform wird auf die Metallschicht des Metall-Keramik-Substrats eine photosensitive Folie aufgebracht, die anschließend an den zu maskierenden Bereichen belichtet wird, um die erste Maskierung zu erhalten. Die unbelichteten Bereiche der photosensitiven Folie können im Anschluss auf fachübliche Weise entfernt werden (zum Beispiel unter Einsatz einer Natriumcarbonatlösung).

Nach dem Aufbringen der ersten Maskierung erfolgt vorzugsweise das Abscheiden einer silberhaltigen Schicht auf die unmaskierten Bereiche der Metallschicht unter Erhalt eines Kontaktbereichs aufweisend Silber. Die silberhaltige Schicht ist vorzugsweise eine Schicht, die aus Silber oder einer Silberlegierung, besonders bevorzugt aus Silber, besteht. Das Abscheiden der silberhaltigen Schicht erfolgt vorzugsweise auf fachübliche Weise. Die silberhaltige Schicht kann zum Beispiel elektrochemisch, stromlos oder chemisch abgeschieden werden. Bevorzugt ist eine chemische Abscheidung durch Aufbringen einer silberhaltigen Lösung unter einem Ladungsaustausch zwischen den Metallen, wobei Metall der Metallschicht teilweise in Lösung geht, während sich das in Lösung befindliche Silber abscheidet. Gemäß einer bevorzugten Ausführungsform enthält die silberhaltige Lösung ein Silbersalz und besonders bevorzugt Silbernitrat. Gemäß einer bevorzugten Ausführungsform handelt es sich bei der silberhaltigen Lösung um eine saure Lösung von Silbernitrat und besonders bevorzugt um eine salpetersaure Lösung von Silbernitrat. Die Konzentration von Silber in der salpetersauren Lösung kann zum Beispiel im Bereich von 0,5 - 1,5 g/l, besonders bevorzugt im Bereich von 0,6 - 1,4 g/l und ganz besonders bevorzugt im Bereich von 0,8 - 1,2 g/l liegen.

Vorzugsweise erfolgt nach dem Abscheiden einer silberhaltigen Schicht auf die unmaskierten Bereiche der Metallschicht unter Erhalt eines Kontaktbereichs aufweisend Silber das Entfernen der ersten Maskierung. Die erste Maskierung kann auf eine fachübliche Weise entfernt werden. Hierzu kann das Metall-Keramik-Substrat beispielsweise mit einer alkalischen Lösung (zum Beispiel einer 2,5%igen Natriumhydroxidlösung) behandelt werden, um die erste Maskierung zu entfernen.

Nach dem Entfernen der ersten Maskierung erfolgt vorzugsweise das Aufbringen einer zweiten Maskierung auf die Metallschicht. Die zweite Maskierung dient dazu, die maskierten Bereiche der Metallschicht des Metall-Keramik-Substrats im darauffolgenden Schritt vor dem Ätzen zu schützen. Dies stellt sicher, dass nur solche Bereiche der Metallschicht des Metall-Keramik-Substrats für das Ätzen zugänglich sind, die unmaskiert und für eine Strukturierung vorgesehen sind. Folglich ist die Maskierung so beschaffen, dass kein Ätzen der maskierten Bereiche der Metallschicht erfolgt. Gemäß einer bevorzugten Ausführungsform erfolgt die Aufbringung der zweiten Maskierung auf Bereiche des Metall-Keramik-Substrats, auf die nicht bereits die erste Maskierung aufgebracht wurde. Die Art der Maskierung ist nicht weiter eingeschränkt. Bei der Maskierung kann es sich beispielsweise um eine fachübliche Negativmaske oder Positivmaske handeln. Die Maskierung kann beispielsweise durch eine Folie (beziehungsweise einen Trockenfilm) oder eine Flüssigkeit, die gegebenenfalls bereichsweise auf die Oberfläche des Metall-Keramik-Substrats gedruckt oder gesprüht wird, erzeugt werden. Dabei können zum Beispiel fachübliche Ätzresists zum Einsatz kommen. Diese Ätzresists enthalten vorzugsweise ein härtbares Polymer (zum Beispiel ein lichthärtbares Polymer). Gemäß einer möglichen Ausführungsform wird auf die teilversilberte Oberfläche des Metall-Keramik-Substrats eine photosensitive Folie aufgebracht, die anschließend an den zu maskierenden Bereichen belichtet wird, um die zweite Maskierung zu erhalten. Die unbelichteten Bereiche der photosensitiven Folie können im Anschluss auf fachübliche Weise entfernt werden (zum Beispiel unter Einsatz einer Natriumcarbonatlösung).

Nach dem Aufbringen der zweiten Maskierung auf die Metallschicht erfolgt vorzugsweise das Ätzen von unmaskierten Bereichen der Metallschicht unter Erhalt einer Strukturierung. Das Ätzen erfolgt vorzugsweise auf fachübliche Weise. Vorzugsweise erfolgt das Ätzen daher mit einer fachüblichen Ätzlösung. Gemäß einer bevorzugten Ausführungsform ist die Ätzlösung aus der Gruppe ausgewählt, die aus $FeCl_3$-Ätzlösungen und $CuCl_2$-Ätzlösungen besteht. Falls erforderlich, kann eine weitere Ätzlösung verwendet werden, zum Beispiel um unmaskierte Bereiche einer optional enthaltenen Verbindungsschicht zu strukturieren. Gemäß einer bevorzugten Ausführungsform kann die weitere Ätzlösung aus der Gruppe ausgewählt sein, die aus Ätzlösungen enthaltend Wasserstoffperoxid und aus Ätzlösungen enthaltend Ammoniumperoxodisulfat besteht. Zum Beispiel kann die weitere Ätzlösung eine Ätzlösung sein, die Ammoniumfluorid und Fluorborsäure (zum Beispiel $HBF_4$) sowie Wasserstoffperoxid und/oder Ammoniumperoxodisulfat enthält.

Vorzugsweise erfolgt nach dem Ätzen von unmaskierten Bereichen der Metallschicht unter Erhalt einer Strukturierung das Entfernen der zweiten Maskierung. Die zweite Maskierung kann auf eine fachübliche Weise entfernt werden. Hierzu kann das Metall-Keramik-Substrat beispielsweise mit einer alkalischen Lösung (zum Beispiel einer 2,5%igen Natriumhydroxidlösung) behandelt werden, um die zweite Maskierung zu entfernen.

Mit dem hierin beschriebenen Verfahren lässt sich ein Metall-Keramik-Substrat erhalten, das mit einer Strukturierung und einem Kontaktbereich aufweisend Silber versehen ist. Durch die Schaffung eines Kontaktbereichs aufweisend Silber wird eine leichtere Anbindung des Chips mit dem Metall-Keramik-Substrat durch gängige Verfahren wie Sintern oder Löten ermöglicht.

Das so erhaltene Metall-Keramik-Substrat zeichnet sich durch eine besonders hohe Temperaturwechselbeständigkeit aus.

**Ausführungsbeispiele**

Die vorliegende Erfindung wird nachstehend durch Ausführungsbeispiele näher beschrieben, die jedoch nicht als einschränkend verstanden werden sollen.

Beispiel:

Für das Beispiel wurde ein Metall-Keramik-Substrat verwendet, bei dem ein Keramikkörper aus einer Siliziumnitridkeramik mit der Abmessung 177,8 x 139 x 0,32 mm beidseitig mit jeweils einer Kupferschicht mit der Abmessung 170 x 132 x 0.3 mm über ein AMB (Active Metal Brazing) -Verfahren, verbunden war. Dieses Kupfer-Keramik-Substrat wurde nach der Herstellung zunächst gereinigt.

Sodann wurde auf beide Kupferschichten des Kupfer-Keramik-Substrats mittels eines Hot Roll Laminator eine photosensitive Folie aufgebracht. Die photosensitive Folie wurde jeweils mit 30 mJ/cm$^2$ an den zu maskierenden Bereichen belichtet, um das in der photosensitiven Folie enthaltene Polymer zu härten und die erste Maskierung zu erhalten. Im Anschluss wurden die unbelichteten Stellen der photosensitiven Folie nasschemisch unter Verwendung einer Natriumcarbonatlösung (Konzentration = 10 g/l) entfernt. Nach dem Aufbringen der ersten Maskierung wurde das Kupfer-Keramik-Substrat durch Spülen gereinigt. Danach wurden auf die unmaskierten Bereiche der Kupferschichten des Kupfer-Keramik-Substrats silberhaltige Kontaktbereiche abgeschieden. Hierzu wurde das mit der ersten Maskierung versehene Kupfer-Keramik-Substrat zunächst mit einer ersten Lösung enthaltend Wasserstoffperoxid und Schwefelsäure vorbehandelt und danach mit einer salpetersauren Silbernitratlösung (Silbergehalt = 1,0 g/l) kontaktiert. Nach der Abscheidung der silberhaltigen Kontaktbereiche wurde das Kupfer-Keramik-Substrat mit Wasser sorgfältig gespült, um vorhandene Rückstände zu entfernen. Anschließend wurde die erste Maskierung in einer Strippanlage mit einer 2,5%igen Natriumhydroxidlösung entfernt.

Im Anschluss daran wurde auf beide mit jeweils silberhaltigen Kontaktbereichen versehenen Kupferschichten des Kupfer-Keramik-Substrats mittels eines Hot Roll Laminator eine photosensitive Folie aufgebracht. Die photosensitive Folie wurde jeweils mit 30 mJ/cm$^2$ an den zu maskierenden Bereichen belichtet, um das in der photosensitiven Folie enthaltene Polymer zu härten und die zweite Maskierung zu erhalten. Danach wurden die unbelichteten Stellen der photosensitiven Folie nasschemisch unter Verwendung einer Natriumcarbonatlösung (Konzentration = 10 g/l) entfernt. Nach dem Aufbringen der zweiten Maskierung wurde das Kupfer-Keramik-Substrat wiederum durch Spülen gereinigt. Anschließend wurden die unmaskierten Bereiche der mit silberhaltigen Kontaktbereichen versehenen Kupferschichten des Kupfer-Keramik-Substrats nasschemisch geätzt. Hierzu wurde das Kupfer-Keramik-Substrat in einer Ätzanlage mit einer salzsauren Kupferchloridlösung (Kupferionengehalt = 160 g/l) enthaltend Wasserstoffperoxid besprüht. Das Ätzen erfolgte bei einer Temperatur von 50°C und bei einem Sprühdruck von 2,8 bar. Durch das Ätzen wurde Material aus den unmaskierten Bereichen der Kupferschicht des Kupfer-Keramik-Substrats abgetragen. Die Metall-Keramik-Substrate wurden danach gespült. Sodann wurden unmaskierte Bereiche der im Metall-Keramik-Substrat enthaltenen Verbindungsschicht ebenfalls nasschemisch geätzt. Hierzu wurde das Metall-Keramik-Substrat wiederum in einer Ätzanlage mit einer Ätzlösung besprüht, die Ammoniumfluorid, Fluorborsäure und Wasserstoffperoxid enthielt. Anschließend wurde das Kupfer-Keramik-Substrat gespült und getrocknet. Danach wurde die zweite Maskierung in einer Strippanlage mit einer 2,5%igen Natriumhydroxidlösung entfernt.

Das so erhaltene Kupfer-Keramik-Substrat wurde mittels Laser zu Einzelteilen mit den Abmessungen (20,5 x 17,0 mm) geschnitten und konnte danach für weitere Untersuchungen und die Herstellung eines elektronischen Bauteils eingesetzt werden.

Vergleichsbeispiel:

Das Vergleichsbeispiel wurde wie das Beispiel durchgeführt, wobei die Reihenfolge der Schritte: (i) Abscheiden einer silberhaltigen Schicht auf die unmaskierten Bereiche der Kupferschicht unter Erhalt eines Kontaktbereichs aufweisend Silber und (ii) Ätzen von unmaskierten Bereichen der Kupferschicht unter Erhalt einer Strukturierung umgekehrt

wurden.

Für das Vergleicheisbeispiel wurde ein analoges Metall-Keramik-Substrat wie im Beispiel verwendet, bei dem ein Keramikkörper aus einer Siliziumnitridkeramik mit der Abmessung 177,8 x 139 x 0,32 mm beidseitig mit jeweils einer Kupferschicht mit der Abmessung 170 x 132 x 0.3 mm über ein AMB (Active Metal Brazing) -Verfahren, verbunden war. Dieses Kupfer-Keramik-Substrat wurde nach der Herstellung zunächst gereinigt.

Sodann wurde auf beide Kupferschichten des Kupfer-Keramik-Substrats mittels eines Hot Roll Laminator eine photosensitive Folie aufgebracht. Die photosensitive Folie wurde jeweils mit 30 mJ/cm$^2$ an den zu maskierenden Bereichen belichtet, um das in der photosensitiven Folie enthaltene Polymer zu härten und die erste Maskierung zu erhalten. Im Anschluss wurden die unbelichteten Stellen der photosensitiven Folie nasschemisch unter Verwendung einer Natriumcarbonatlösung (Konzentration = 10 g/l) entfernt. Nach dem Aufbringen der ersten Maskierung wurde das Kupfer-Keramik-Substrat durch Spülen gereinigt. Anschließend wurden die unmaskierten Bereiche der Kupferschichten des Kupfer-Keramik-Substrat nasschemisch geätzt. Hierzu wurde das Kupfer-Keramik-Substrat in einer Ätzanlage mit einer salzsauren Kupferchloridlösung (Kupferionengehalt = 160 g/l) enthaltend Wasserstoffperoxid besprüht. Das Ätzen erfolgte bei einer Temperatur von 50°C und bei einem Sprühdruck von 2,8 bar. Durch das Ätzen wurde Material aus den unmaskierten Bereichen der Kupferschichten des Kupfer-Keramik-Substrats abgetragen. Die Metall-Keramik-Substrate wurden danach gespült. Sodann wurden unmaskierte Bereiche der im Metall-Keramik-Substrat enthaltenen Verbindungsschicht ebenfalls nasschemisch geätzt. Hierzu wurde das Metall-Keramik-Substrat wiederum in einer Ätzanlage mit einer Ätzlösung besprüht, die Ammoniumfluorid, Fluorborsäure und Wasserstoffperoxid enthielt. Anschließend wurde das Kupfer-Keramik-Substrat gespült und getrocknet. Danach wurde die erste Maskierung in einer Strippanlage mit einer 2,5%igen Natriumhydroxidlösung entfernt.

Sodann wurde auf beide geätzten Oberflächen des Kupfer-Keramik-Substrats mittels eines Hot Roll Laminator eine photosensitive Folie aufgebracht. Die photosensitive Folie wurde jeweils mit 30 mJ/cm$^2$ an den zu maskierenden Bereichen belichtet, um das in der photosensitiven Folie enthaltene Polymer zu härten und die zweite Maskierung zu erhalten. Danach wurden die unbelichteten Stellen der photosensitiven Folie nasschemisch unter Verwendung einer Natriumcarbonatlösung (Konzentration = 10 g/l) entfernt. Nach dem Aufbringen der zweiten Maskierung wurde das Kupfer-Keramik-Substrat wiederum durch Spülen gereinigt. Danach wurden auf die unmaskierten Bereiche der Kupferschichten des Kupfer-Keramik-Substrats silberhaltige Kontaktbereiche abgeschieden. Hierzu wurde das mit der zweiten Maskierung versehene Kupfer-Keramik-Substrat zunächst mit einer ersten Lösung enthaltend Wasserstoffperoxid und Schwefelsäure vorbehandelt und danach mit einer salpetersauren Silbernitratlösung (Silbergehalt = 1,0 g/l) kontaktiert. Nach der Abscheidung der silberhaltigen Kontaktbereiche wurde das Kupfer-Keramik-Substrat mit Wasser sorgfältig gespült, um vorhandene Rückstände zu entfernen. Anschließend wurde die zweite Maskierung in einer Strippanlage mit einer 2,5%igen Natriumhydroxidlösung entfernt.

Das so erhaltene Kupfer-Keramik-Substrat wurde mittels Laser zu Einzelteilen mit den Abmessungen (20,5 x 17,0 mm) geschnitten und konnte danach für weitere Untersuchungen und die Herstellung eines elektronischen Bauteils eingesetzt werden.

Auswertung:

Für die im Beispiel und dem Vergleichsbeispiel erhaltenen Metall-Keramik-Substrate wurde das Verhältnis S (BC$_{solid}$) / S (BC$_{total}$) ermittelt. Hierzu wurden, wie hierin beschrieben, die Metall-Keramik-Substrate senkrecht zur Haupterstreckungsebene der jeweiligen Keramikkörper geschnitten und Aufnahmen der so erhaltenen Querschnitte durch ein Lichtmikroskop erstellt. In den Querschnitten wurden jeweils die Punkte A, B und C bestimmt. Danach wurde für jedes der Metall-Keramik-Substrate das Verhältnis S (BC$_{solid}$) / S (BC$_{total}$) ermittelt. Hierzu wurden zehn unterschiedliche Querschnitte eines Strukturierungsbereichs in der Metallschicht des jeweiligen Metall-Keramik-Substrats untersucht, das Verhältnis S (BC$_{solid}$) / S (BC$_{total}$) für jeden dieser Querschnitte wurde bestimmt, und der Mittelwert aus den Verhältnissen S (BC$_{solid}$) / S (BC$_{total}$) für jeden dieser Querschnitte wurde gebildet, um zum Verhältnis S (BC$_{solid}$) / S (BC$_{total}$) für das jeweilige Metall-Keramik-Substrat zu gelangen. Ferner wurde die Standardabweichung SSD bestimmt.

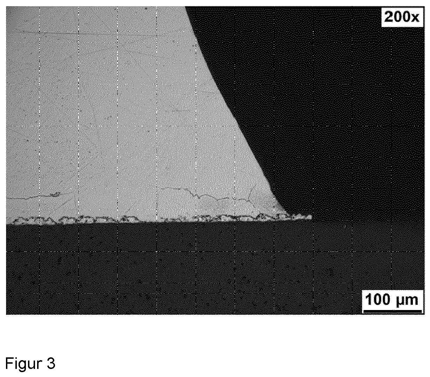

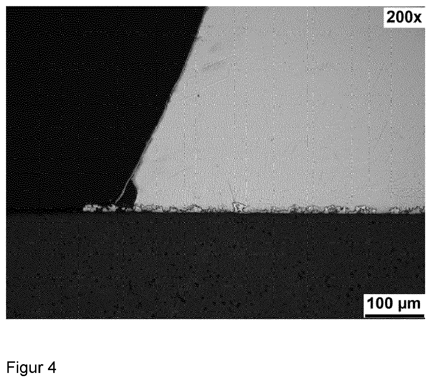

Figur 3 zeigt exemplarisch eine lichtmikroskopische Aufnahme des Querschnitts eines Strukturierungsbereichs eines Metall-Keramik-Substrats gemäß Beispiel, während Figur 4 exemplarisch eine lichtmikroskopische Aufnahme des Querschnitts eines Strukturierungsbereichs eines Metall-Keramik-Substrats gemäß Vergleichsbeispiel zeigt.

Die Ergebnisse sind in Tabelle 1 dargestellt.

Tabelle 1:

|  | S (BC$_{solid}$) / S (BC$_{total}$) | Standardabweichung SSD |
|---|---|---|
| Beispiel | 99,3% | 0,4% |
| Vergleichsbeispiel | 58,4% | 12,7% |

Die Metall-Keramik-Substrate wurden auf ihre Temperaturwechselbeständigkeit hin untersucht. Hierzu wurden Temperaturwechselbeständigkeitstests durchgeführt.

Temperaturwechselbeständigkeitstest:

Zur Vorbereitung des Temperaturwechselbeständigkeitstests wurde zunächst mittels Ultraschallmikroskopie (PVA Tepla SAM300) überprüft, ob die Metall-Keramik-Substrate in einwandfreiem Zustand waren. Für den Test wurden ausschließlich Metall-Keramik-Substrate verwendet, die keine Delamination zwischen Keramikkörper und Metallschicht oder sonstige Deformationen, die zur Delamination der Metallschicht vom Keramikkörper führen könnten (zum Beispiel Risse), zeigten. Zum Testen der Temperaturwechselbeständigkeit wurden die Metall-Keramik-Substrate wiederholt für einen Zeitraum von jeweils fünf Minuten einer kalten Flüssigkeit (Temperatur -65°C, Galden Do2TS) und einer heißen Flüssigkeit (Temperatur +150°C, Galden Do2TS) in einer Zyklierkammer (ESPEC TSB-21 51) ausgesetzt. Die Metall-Keramik-Substrate wurden alle 1000 Zyklen mittels Ultraschallmikroskopie (PVA Tepla SAM300) erneut auf Delamination und sonstige Deformationen überprüft. Der Test wurde nach 3000 Zyklen beendet. Danach wurden die Metall-Keramik-Substrate wiederum mittels Ultraschallmikroskopie (PVA Tepla SAM300) auf Delamination und sonstige Deformationen überprüft. Der Zustand der jeweiligen Metall-Keramik-Substrate nach Durchführung des Temperaturwechselbeständigkeitstests wurde mit dem Zustand der Metall-Keramik-Substrate vor Durchführung des Temperaturwechselbeständigkeitstests im Hinblick auf eine Delamination und sonstige Deformationen verglichen. Delaminationen und sonstige Deformationen (zum Beispiel Risse) waren hierbei als weiße Verfärbungen im Ultraschallbild erkennbar.

Die Ergebnisse sind in Tabelle 2 dargestellt.

Tabelle 2:

|  | Ergebnis des Temperaturwechselbeständigkeitstests |
|---|---|
| Beispiel | Sehr gut: Es waren keine Delaminationen erkennbar |
| Vergleichsbeispiel | Mangelhaft: An den Ecken des Metall-Keramik-Substrats waren ausgeprägte Delaminationen erkennbar |

Die Ergebnisse zeigen, dass das erfindungsgemäße Metall-Keramik-Substrat dem Metall-Keramik-Substrat des Vergleichsbeispiels im Hinblick auf die Temperaturwechselbeständigkeit deutlich überlegen ist.

**Bezugszeichenliste:**

1     Metall-Keramik-Substrat
2     Haupterstreckungsebene
4     Strukturierungsbereich
8     Kontaktbereich
10    Keramikkörper
15    Hauptbegrenzungsfläche
20    Metallschicht
22    Ausnehmung
24    Metallhauptfläche
40    Konturlinie
50    Festes Material
200   Weitere Metallschicht

**Patentansprüche**

1. Metall-Keramik-Substrat aufweisend

a) einen Keramikkörper, der eine Haupterstreckungsebene aufweist,
b) eine Metallschicht, die flächig mit dem Keramikkörper verbunden ist, wobei die Metallschicht einen Strukturierungsbereich aufweist, der

(i) bereichsweise festes Material und
(ii) bereichsweise nicht-festes Material

umfasst, und

c) einen auf der Metallschicht angeordneten Kontaktbereich aufweisend Silber,
**dadurch gekennzeichnet, dass**
in einem Querschnitt durch das Metall-Keramik-Substrat senkrecht zur Haupterstreckungsebene der Strukturierungsbereich eine Geometrie aufweist, wobei folgendes Erfordernis erfüllt ist:

$$S\ (BC_{solid})\ /\ S\ (BC_{total}) > 60\%,$$

wobei:

$S\ (BC_{total})$ für die gesamte Länge der Strecke zwischen den Punkten B und C steht und $S\ (BC_{solid})$ für die Länge der Strecke zwischen den Punkten B und C steht, die festes Material schneidet,
wobei die Punkte B und C wie folgt bestimmt werden:

1. die Ausgleichsgerade zwischen dem Keramikkörper und der Metallschicht wird bestimmt;
2. die Konturlinie wird bestimmt, die das feste Material vom nicht-festen Material trennt;
3. auf einer Senkrechten zur Ausgleichsgeraden wird im Abstand von 150 $\mu$m zur Ausgleichsgeraden der Punkt A ermittelt, in dem die Senkrechte zur Ausgleichsgeraden die Konturlinie schneidet;
4. auf einer Senkrechten zur Ausgleichsgeraden wird im Abstand von 80 $\mu$m zur Ausgleichsgeraden der Punkt B ermittelt, in dem die Senkrechte zur Ausgleichsgeraden die Konturlinie schneidet;
5. auf einer Geraden, die durch die Punkte A und B verläuft, wird der Punkt C ermittelt, in dem die Gerade die Ausgleichsgerade schneidet.

2. Metall-Keramik-Substrat gemäß Anspruch 1, **dadurch gekennzeichnet, dass** die Keramik des Keramikkörpers aus der Gruppe ausgewählt ist, die aus Aluminiumnitridkeramiken, Siliziumnitridkeramiken und Aluminiumoxidkeramiken besteht.

3. Metall-Keramik-Substrat gemäß Anspruch 1 oder Anspruch 2, **dadurch gekennzeichnet, dass** die Metallschicht Kupfer umfasst.

4. Metall-Keramik-Substrat gemäß einem der vorangegangenen Ansprüche, **dadurch gekennzeichnet, dass** das feste Material Metall der Metallschicht enthält.

5. Metall-Keramik-Substrat gemäß einem der vorangegangenen Ansprüche, **dadurch gekennzeichnet, dass** das nicht-feste Material gasförmiges Material enthält.

6. Metall-Keramik-Substrat gemäß einem der vorangegangenen Ansprüche, **dadurch gekennzeichnet, dass** folgendes Erfordernis erfüllt ist:

$$S\ (BC_{solid})\ /\ S\ (BC_{total}) > 95\%.$$

7. Metall-Keramik-Substrat gemäß einem der vorangegangenen Ansprüche, **dadurch gekennzeichnet, dass** die Stichprobenstandardabweichung SSD des Verhältnisses $S\ (BC_{solid})\ /\ S\ (BC_{total})$ über wenigstens zehn unterschiedliche Querschnitte des Strukturierungsbereichs der Metallschicht nicht mehr als 10% beträgt.

8. Elektronisches Bauteil aufweisend ein Metall-Keramik-Substrat gemäß einem der vorangegangenen Ansprüche.

9. Verfahren zur Herstellung eines Metall-Keramik-Substrats, das mit einer Strukturierung und einem Kontaktbereich aufweisend Silber versehen ist, umfassend die Schritte:

a) Bereitstellung eines Metall-Keramik-Substrats aufweisend

a1) einen Keramikkörper und

a2) eine mit dem Keramikkörper flächig verbundene Metallschicht,

b) Aufbringen einer ersten Maskierung auf die Metallschicht,

c) Abscheiden einer silberhaltigen Schicht auf die unmaskierten Bereiche der Metallschicht unter Erhalt eines Kontaktbereichs aufweisend Silber,

d) Entfernen der ersten Maskierung,

e) Aufbringen einer zweiten Maskierung auf die Metallschicht,

f) Ätzen von unmaskierten Bereichen der Metallschicht unter Erhalt einer Strukturierung und

g) Entfernen der zweiten Maskierung.

Figur 1

Figur 2

Figur 3

Figur 4

Europäisches
Patentamt

European
Patent Office

Office européen
des brevets

# EUROPÄISCHER RECHERCHENBERICHT

**Nummer der Anmeldung**

EP 22 18 7751

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | EP 3 661 337 A1 (DENKA COMPANY LTD [JP]) 3. Juni 2020 (2020-06-03) | 1-8 | INV. C04B37/02 H01L21/306 H01L23/15 C04B41/53 |
| A | * Ansprüche 1-8; Abbildungen 1-3; Beispiele 1-15 * | 9 | |
| Y | DE 10 2012 214901 A1 (INFINEON TECHNOLOGIES AG [DE]) 28. Februar 2013 (2013-02-28) | 1-8 | |
| A | * Absätze [0022] - [0025]; Ansprüche 1-24; Abbildungen 1-3 * | 9 | |
| A | WO 2021/149789 A1 (DENKA COMPANY LTD [JP]) 29. Juli 2021 (2021-07-29) * Ansprüche 1-11; Abbildung 1 * | 1-9 | |
| A | DE 10 2020 119208 A1 (ROGERS GERMANY GMBH [DE]) 27. Januar 2022 (2022-01-27) * Absätze [0040] - [0044]; Ansprüche 1-11; Abbildungen 1-10 * | 1-9 | |

**RECHERCHIERTE SACHGEBIETE (IPC)**

C04B
H01L

Der vorliegende Recherchenbericht wurde für alle Patentansprüche erstellt

| Recherchenort | Abschlußdatum der Recherche | Prüfer |
|---|---|---|
| Den Haag | 19. Januar 2023 | Süzük, Kerem Güney |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes
Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 22 18 7751

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-01-2023

| Im Recherchenbericht angeführtes Patentdokument | Datum der Veröffentlichung | Mitglied(er) der Patentfamilie | Datum der Veröffentlichung |
|---|---|---|---|
| EP 3661337 A1 | 03-06-2020 | CN 110945974 A | 31-03-2020 |
| | | EP 3661337 A1 | 03-06-2020 |
| | | JP 7010950 B2 | 26-01-2022 |
| | | JP WO2019022133 A1 | 11-06-2020 |
| | | KR 20200029480 A | 18-03-2020 |
| | | US 2020163210 A1 | 21-05-2020 |
| | | WO 2019022133 A1 | 31-01-2019 |
| DE 102012214901 A1 | 28-02-2013 | CN 103035601 A | 10-04-2013 |
| | | DE 102012214901 A1 | 28-02-2013 |
| | | US 2013049204 A1 | 28-02-2013 |
| WO 2021149789 A1 | 29-07-2021 | CN 114982388 A | 30-08-2022 |
| | | EP 4096369 A1 | 30-11-2022 |
| | | JP WO2021149789 A1 | 29-07-2021 |
| | | KR 20220131242 A | 27-09-2022 |
| | | WO 2021149789 A1 | 29-07-2021 |
| DE 102020119208 A1 | 27-01-2022 | DE 102020119208 A1 | 27-01-2022 |
| | | WO 2022018061 A1 | 27-01-2022 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3744120 A
- DE 2319854 C2
- JP 4812985 B
- DE 102017114893 A1